# EUROPEAN PATENT APPLICATION

(11) **EP 4 067 996 A1**
(43) Date of publication of application: **05.10.2022**
(21) Application number: 21166726.6
(22) Date of filing: 01.04.2021
(51) Int. Cl.: G03F 1/42, G03F 1/38, G03F 1/84, G03F 9/00, G03F 7/20

(54) **PATTERNING DEVICE FOR A LITHOGRAPHIC APPARATUS AND METHOD**

(71) Applicant: ASML Netherlands B.V., 5500 AH Veldhoven (NL)
(72) Inventor: VAN DE KERKHOF, Marcus, Adrianus, 5500 AH Veldhoven (NL)
(74) Representative: ASML Netherlands B.V.

(57) **Abstract**

A patterning device for a lithographic apparatus arranged to project a pattern from the patterning device onto a substrate, the patterning device comprising: an imaging area having opposing first sides extending parallel to a scanning direction of the lithographic apparatus and opposing second sides extending perpendicularly to the scanning direction, and at least one sensing mark located adjacent to at least one second side of the imaging area; wherein the at least one sensing mark is located a predetermined distance in the scanning direction away from the at least one second side of the imaging area and extends a width in the scanning direction such that the at least one sensing mark, when projected onto the substrate, fits within a scribe line on the substrate.

## Description

### FIELD

The present invention relates to a patterning device for a lithographic apparatus, more particularly, the patterning device comprising sensing marks, and a method of its operation.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The imaging area of an EUV reticle may be 104x132 mm² (X-perpendicular to the scanning direction, Y-scanning direction), centred in the middle. Around that there may be a blackborder of 2 mm in X and 3 mm in Y.

An area for reticle alignment marks is reserved at opposing sides of the image field which are parallel to the X direction, plus an additional area for so-called Reticle Shape Correction (RSC) marks at opposing sides of the image field which are parallel to the Y direction.

For NA(numerical aperture)=0.33, this corresponds to a full-field; but for NA=0.55, this corresponds to a half-field only, which limits design flexibility for customers and impacts the effective throughput of the lithographic apparatus (more time needs to be spent on stepping and turn around).

It may be desirable to provide an apparatus and method that overcomes or mitigates one or more problems associated with the prior art.

### SUMMARY

According to a first aspect of the present invention, there is provided a patterning device for a lithographic apparatus arranged to project a pattern from the patterning device onto a substrate, the patterning device comprising: an imaging area having opposing first sides extending parallel to a scanning direction of the lithographic apparatus and opposing second sides extending perpendicularly to the scanning direction, and at least one sensing mark located adjacent to at least one second side of the imaging area; wherein the at least one sensing mark is located a predetermined distance in the scanning direction away from the at least one second side of the imaging area and extends a width in the scanning direction such that the at least one sensing mark, when projected onto the substrate, fits within a scribe line on the substrate.

This may have an advantage that the sensing mark may not overlap with neighbouring fields on the substrate. Furthermore, this may have an advantage of reducing or avoiding covering of the sensing marks by a reticle masking Y-blade. This may allow the scanning requirements on reticle masking Y-blades to be removed. This may remove a bottleneck for throughput of the lithographic apparatus LA roadmap and reduce cost for the reticle masking module.

Adjacent the at least one second side of the imaging area may be considered to be located within an area of the patterning device virtually extending away from the at least one second side of the imaging area in the scanning direction.

A sensing mark may be considered to be a (passive) reflective structure on the patterning device which is projected onto the substrate to be measurable by a sensor. The (active) sensor is located at substrate level.

The predetermined distance in the scanning direction may be at least one of the width in the scanning direction of a blackborder adjacent to the imaging area, and substantially 3mm

The width in the scanning direction of the sensing mark may be at least one of less than 200 micron and less than 400 micron.

The sensing mark may be separated from the imaging area by a blackborder. The blackborder width in the scanning direction may be 3mm. Unless the blackborder contains patterns in which case quiet area requirements should be respected.

The scribe line may have a width in the scanning direction of 200 micron at patterning device level, e.g. for NA=0.33. Thus, for NA=0.33, the width in the scanning direction of the sensing mark may be less than 200 micron.

The magnification from patterning device to substrate may be 1/4x in Y for NA=0.33.

The scribe line may have a width of 50 micron at substrate level.

The scribe line may have a width in the scanning direction of 400 micron at patterning device level, e.g. for NA=0.55. Thus, for NA=0.55, the width in the scanning direction of the sensing mark may be less than 400 micron.

The magnification from patterning device to substrate may be 1/8x in Y for NA=0.55.

The sensing mark may comprise an alignment mark.

The sensing mark may comprise an optical aberration measurement mark.

The alignment mark may comprise a transmission image sensor (TIS) alignment mark.

The patterning device may comprise reticle shape correction marks only adjacent to one or more of the first sides of the imaging area. That is, the reticle shape correction marks may not be adjacent to the second sides of the imaging area.

The patterning device may comprise no reticle shape correction marks.

The alignment mark comprises y and x fine-alignment marks.

The y fine-alignment mark measures the alignment vector in the scanning Y direction. The y fine-alignment mark may be orientated in the X direction, i.e. the longest dimensions are in X-direction.

The x fine-alignment mark measures the alignment vector in the scanning Y direction. The y fine-alignment mark may be orientated in the X direction, i.e. the longest dimensions are in X-direction.

The alignment mark may comprise at least one coarse alignment mark, wherein the at least one coarse alignment mark may be located in an area coverable with a reticle masking X-blade.

The at least one coarse alignment mark may be located within an area of the patterning device which is not within either an area of the patterning device virtually extending away from at least one second side of the imaging area in the scanning direction or an area of the patterning device virtually extending away from at least one first side of the imaging area in the direction perpendicular to the scanning direction. That is, corner areas of the patterning device.

The reticle masking X-blade may be semi-stationary. That is, the X-blade may not move when the patterning device is being scanned.

The patterning device may further comprise at least one reference alignment mark, wherein the at least one reference alignment mark may be located in an area coverable with a reticle masking X-blade.

This may have an advantage of allowing calibration out of any possible impact of patterning device image field structures on the aligned position.

According to a second aspect of the present invention, there is provided a lithographic apparatus arranged to project a pattern from a patterning device onto a substrate, wherein the lithographic apparatus comprises an illumination system configured to condition a radiation beam, wherein the illumination system is configured to project the radiation beam onto the patterning device, and wherein the lithographic apparatus comprises the patterning device of any preceding claim.

The radiation may be EUV radiation and the lithographic apparatus may be an EUV lithographic apparatus.

According to a third aspect of the present invention, there is provided a method of projecting onto a substrate at least one sensing mark on a patterning device as described above such that the at least one sensing mark fits within a scribe line on the substrate.

The sensing mark may comprise an alignment mark. The method may further comprise aligning the patterning device with the substrate using the alignment mark.

The method may further comprise measuring the XY-aligned position with a plurality of offsets in Y with the most accurate value being the one furthest from the patterning device.

The method may be enhanced with a flare model to determine the best alignment value.

The method may further comprise using correction feedback or other overlay process control schemes to remove any residual patterning device alignment offsets.

According to a fourth aspect of the present invention, there is provided a patterning device for a lithographic apparatus arranged to project a pattern from the patterning device onto a substrate, the patterning device comprising: an imaging area having opposing first sides extending parallel to a scanning direction of the lithographic apparatus and opposing second sides extending perpendicularly to the scanning direction; wherein the imaging area is shifted with respect to a patterning device centre in the scanning direction such that a first spacing between one of the second sides of the imaging area to an adjacent edge of the patterning device is less than a second spacing between the other of the second sides of the imaging area to an opposing adjacent edge of the patterning device.

The first spacing may be at least one of in a range of 0.4mm to 10mm, and in a range of 5 to 10mm.

The first spacing may be approximately 5mm.

The patterning device may be positioned adjacent to another patterning device in the scanning direction, the adjacent edges of the patterning devices being in contact with each other such that the distance between the two respective imaging areas equals the first spacings of the respective patterning devices added together.

This may have an advantage of enabling a full field to be imaged onto a substrate for a lithographic apparatus having a numerical aperture (NA)=0.55 whilst reducing the % loss of the imaging area imaged on the substrate when compared to patterning devices with the imaging area centred in the patterning device.

According to a fifth aspect of the present invention, there is provided a method of using high-resolution reflectivity measurements of a patterning device blank prior to deposition of absorber to apply a correction to the local linewidth and/or optical proximity corrections features and/or sub-resolution assist features.

These measurements may be similar to optical proximity corrections and in addition to nominal optical proximity corrections.

This may improve reflectivity and centre wavelength related items.

The method may further comprise, after absorber deposition on the patterning device, using high-resolution reflectivity or ellipsometry measurements to determine local absorber thickness variations, and using these measurements to apply a correction to the local linewidth and/or optical proximity corrections features and/or sub-resolution assist features.

These measurements may be similar optical proximity corrections and in addition to nominal optical proximity corrections.

This may improve absorber and 3D related items.

The patterning device may comprise an imaging area having opposing first sides extending parallel to a scanning direction of a lithographic apparatus and opposing second sides extending perpendicularly to the scanning direction. The method may further comprise shifting the imaging area with respect to a patterning device centre in the scanning direction such that a first spacing between one of the second sides of the imaging area to an adjacent edge of the patterning device is less than a second spacing between the other of the second sides.

The method may allow the imaging area to be shifted closer to the edge of the patterning device than was previously possible whilst maintaining the required sub-nm thickness accuracy and thus keeping within the desired specifications for reflectivity uniformity.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic diagram of a patterning device with an imaging area centered in the patterning device according to an embodiment of the invention;
- Figure 3 depicts a schematic diagram of a two patterning devices with an imaging area centered in the patterning devices;
- Figure 4 depicts a schematic diagram of two patterning devices with an imaging area shifted in the patterning devices according to an embodiment of the invention.

### DETAILED DESCRIPTION

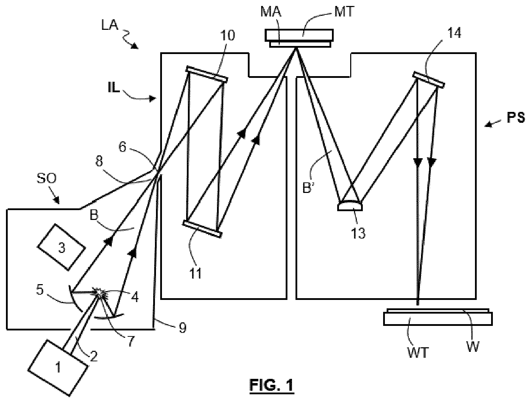

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

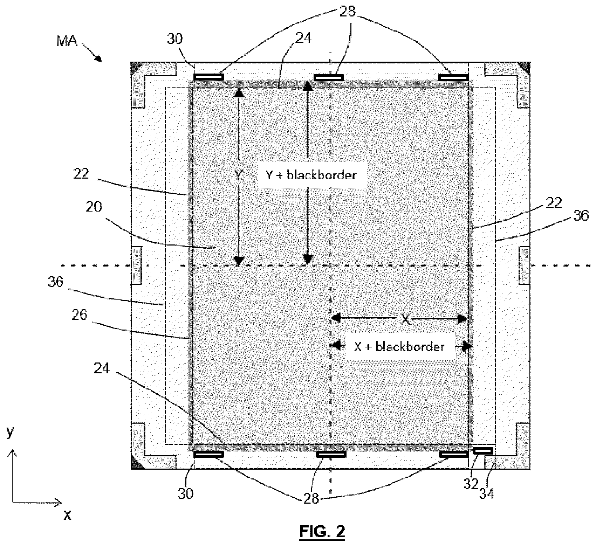

Figure 2 shows a patterning device MA (e.g., a mask or reticle) with an imaging area 20 centered in the patterning device MA. The patterning device MA is shown pattern side down. The lithographic apparatus LA may scan the patterning device MA in a scanning direction (Y direction) as shown, i.e. up and down on the page. The X direction may be taken perpendicularly to the Y direction as shown, i.e. side to side on the page.

In this embodiment, the imaging area 20 is rectangular. The imaging area 20 has opposing first sides 22 extending parallel to the scanning (Y) direction of the lithographic apparatus LA and opposing second sides 24 extending perpendicularly to the scanning direction (i.e. in the X direction). In Figure 2, the first sides 22 are located at the left and right, and the second sides 24 are located at the top and bottom. The first sides 22 are longer than the second sides 24. The distance references X and Y in Figure 2 are the exposure field size Xmax=52mm, Ymax=66mm. Thus, the imaging area 20 is 104x132mm² (X, Y). Around the imaging area 20 there is a blackborder 26. In X direction the blackborder 26 can be between 1-4mm. In Y direction the blackborder 26 can be between 1-4mm. It will be appreciated that, in other embodiments, the imaging area 20 may be a different shape and size.

Alignment marks 28 are located adjacent to the second sides 24. In Figure 2, alignment marks 28 are shown next to the second sides 24, i.e. below the lower of the second sides 24 and above the upper of the second sides 24. The alignment marks 28 are located outside the black border 26 within areas 30 (shown by dashed lines) of the patterning device MA virtually extending away from the second sides 24 in the scanning (Y) direction.

In this embodiment, there are three alignment marks 28 located next to the lower of the second sides 24 and three alignment marks 28 located next to the upper of the second sides 24. It will be appreciated that, in other embodiments, there may a different number of alignment marks (e.g. only one alignment mark adjacent to at least one second side 24). Although there are two sets of three alignment marks 28 in this embodiment, for brevity, a single alignment mark and second side 24 will be referred to below. However, it will be appreciated that any features described in relation to this alignment mark may be equally applicable to the rest of the alignment marks 28.

In this embodiment, the alignment mark 28 is a transmission image sensor (TIS) alignment mark. However, in other embodiments, they may be other types of alignment marks or, more generally, other types of sensing marks. For example, the sensing marks may comprise an optical aberration measurement mark. The term "aberrations" should be intended to include all forms of deviation of a wavefront from a perfect spherical wavefront. That is, the term "aberrations" may relate to the placement of an image (e.g. the second, third and fourth Zernike coefficients) and/or to higher order aberrations such as those which relate to Zernike coefficients having a Noll index of 5 or more.

In embodiments, the alignment mark 28 is located between 1-4mm (in Y) away from the imaging area 20 (i.e. the width of the blackborder 26 (in Y)). The alignment mark 28 may be placed directed adjacent (in contact with) the blackborder 26 unless the blackborder 26 contains patterns in which case quiet area requirements should be respected. More generally, the alignment mark 28 may be located a predetermined distance away from the imaging area 20. It will be appreciated that, in other embodiments, the blackborder may have a different width in the Y direction, i.e. more than 4mm or less than 1mm

Importantly, the alignment mark 28 has a width in the scanning (Y) direction such that the alignment mark 28, when projected onto the substrate W, fits within a scribe line (not shown) on the substrate W.

The alignment mark 28 may be orientated in the X direction (i.e. the longest dimensions are in the X-direction). The alignment mark 28 may include two fine alignment marks (x fine-alignment mark and y fine-alignment mark). The x and y fine-alignment marks may be orientated in the X direction (i.e. the longest dimensions are in the X-direction). The alignment mark 28 may be a single reflective structure, or might be split into segments. The alignment mark 28 may have reflective and absorber areas. The alignment mark 28 may have dimensions in the X direction between 50 and 500 micron (or may be bigger or smaller). The x fine-alignment mark may have a width in the Y direction which is less than the width in the Y direction of the y fine-alignment mark, or vice versa. Overall, the alignment mark 28 may have a maximum width of less than 200 micron in the Y direction. In addition, the overall length of the alignment mark 28 may be made up from the length in the X direction of the x and y fine-alignment marks and a gap between them.

Since, in embodiments, the maximum width of the alignment mark is less than 200 micron in the scanning (Y) direction, the alignment mark 28 can fit within the scribe line on the substrate W - the scribe line at patterning device MA level has a width of 200 micron in the Y direction, i.e. for NA=0.33. The scribe line on the substrate W may have width in the scanning (Y) direction of 50 micron, i.e. at a magnification from patterning device MA to substrate W of 1/4x for NA=0.33. For NA=0.55, the scribe line at patterning device MA level has a width of 400 micron in the Y direction. Thus, in this embodiment, the alignment mark 28 may have a maximum width in the Y direction of less than 400nm. The scribe line on the substrate W may have width in the scanning (Y) direction of 50 micron, i.e. at a magnification from patterning device MA to substrate W of 1/8x for NA=0.55. It will be appreciated that, in embodiments, the width of the alignment mark 28 in the Y direction may be set to a size such that the alignment mark 28, when projected onto the substrate W, fits within a scribe line on the substrate W.

Previously, an alignment mark included other alignment marks, such as coarse alignment marks (i.e. supporting coarse capturing features) located with the fine alignment marks. With these coarse alignment marks, the overall width of the alignment mark in the Y direction may have been greater than the width in the Y direction of the scribe line at patterning device level (e.g. greater than 200 micron). The alignment mark may have been surrounded by an absorber quiet zone.

In embodiments, as shown in Figure 2, a coarse alignment mark 32 may be located in a corner area 34 (shown by dotted lines) of the patterning device MA. More particularly, at least one coarse alignment mark 32 may be located within the corner area 34 of the patterning device MA which is not within either the area 30 of the patterning device MA virtually extending away from at least one second side 24 of the imaging area 20 in the scanning (Y) direction or an area 36 (shown by dashed lines) of the patterning device MA virtually extending away from at least one first side 22 of the imaging area 20 in the direction perpendicular to the scanning direction (i.e. the X direction). Although only one corner area 34 and one coarse alignment mark 32 is shown for clarity, it will be appreciated that there may be four corner areas 34 with coarse alignment marks 32. Sensor patterns may be designed such that two alignment marks orientated in the X direction (i.e. the longest dimensions are in the X-direction) in the corners may be measured simultaneously to optimize throughput. Marks orientated in the Y direction, i.e. the longest dimensions are in Y-direction, may only be needed since the field only extends <1 mm outwards from the first side 22 blackborders 26. These marks orientated in the Y direction are typically not used for alignment, but for reticle shape correction (RSC).

More generally, coarse alignment marks 32 may be located in an area coverable with a reticle masking X-blade (not shown). The reticle masking X-blade may be semi-stationary. That is, the X-blade may not move when the patterning device MA is being scanned. In principle, coarse alignment marks 32 may be located on the first side 22, in the area 36, or even a bit beyond that area (as this area may still be bladed by the reticle masking X-blade). But, in practice, the separation in the X direction between corner marks may be fixed by a current sensor layout to support parallel measurements, so it may be desirable to maintain this for new reticle design.

Having the alignment mark 28 with a width in the Y direction of less than 200 microns and being located close enough to the imaging area 20 (e.g. being a predetermined distance of approximately 3mm away from the imaging area 20 in the Y direction) means that the alignment mark 28 will coincide with the scribe line at the substrate W. This may have an advantage that the alignment mark 28 may not overlap with neighbouring fields on the substrate W. Furthermore, this may have an advantage of reducing or avoiding covering of the alignment mark 28 by a reticle masking Y-blade.

Previously, to avoid TIS structures (e.g. TIS alignment marks) printing into the neighbouring fields, they needed to be perfectly shielded by reticle masking blades. This makes the dynamic scanning tolerances of the scanning reticle Y-blades critical for the imaging function of the lithographic apparatus LA. As scan speeds increase with the ever-increasing source power, this is considered a bottleneck, especially for high-NA lithographic apparatus LA.

Provided the reflectivity of the non-image area of the patterning device MA can be reduced to <0.5% (which is considered realistic given recent improvements in several blackborder processes), embodiments would allow the scanning requirements on reticle masking Y-blades to be removed. This may remove a bottleneck for throughput of the lithographic apparatus LA roadmap and reduce cost for the reticle masking module.

It should be noted that this is one of the few intrinsic advantages of EUV: reflectivity is intrinsically very low for almost all materials, unless one forms special structures such as a Bragg reflector. So it is relatively very easy to meet the above <0.5% requirement, and synchronized-scanning reticle masking may not be needed except to shield the TIS alignment marks on the patterning device MA.

The patterning device MA may be aligned using the alignment mark 28. In embodiments, as a refinement, any possible impact of the patterning device MA image field structures on the aligned position may be calibrated out. This may be by measuring the XY-aligned position with a plurality of offsets in Y with the most accurate value being the one furthest from the patterning device MA. Another option may be using correction feedback or other overlay process control schemes to remove any residual patterning device MA alignment offsets. A further option may be to include at least one reference alignment mark (including quiet areas) in the area coverable with a reticle masking X-blade. More particularly, in one or more of the corner areas 34.

Previously, so-called Reticle Shape Correction (RSC) marks may be located at the left and right sides (and bottom and top) of the patterning devices (i.e. at each of the four sides). However, the RSC-marks are not a primary lithographic apparatus functionality and may not be necessary in practice. Further, these RSC marks may be limited to RSC marks at the left/right side only. That is, in embodiments, the patterning device MA may comprise reticle shape correction marks (not shown) only adjacent to one or more of the first sides 22 of the imaging area 20. That is, only in the area(s) 36 of the patterning device MA virtually extending away from the first side(s) 22 of the imaging area 20 in the X direction. The reticle shape correction marks may not be adjacent to the second sides 24 of the imaging area 20. That is, not within areas 30 of the patterning device MA virtually extending away from the second sides 24 in the Y direction. In other embodiments, and as shown in Figure 2, the patterning device MA may comprise no reticle shape correction marks.

Having the RSC marks only adjacent to one or more of the first sides 22 of the imaging area 20, or not present on the patterning device MA at all, means that they will not be printed into the neighbouring fields or need to be shielded by the reticle masking Y-blades.

The patterning device MA of Figure 2, for Numerical Aperture (NA)=0.33, corresponds to a full-field. However, for NA=0.55, this corresponds to a half-field only, which limits design flexibility and impacts the effective throughput of the lithographic apparatus LA (more time needs to be spent on stepping and turn around).

For NA=0.55, it is proposed to alleviate this throughout loss by using two patterning devices MA on an extended clamp. However, this may have a problem as will be described.

From a second side of the imaging area to an adjacent edge of the patterning device, the distance is 10mm in Y (i.e. 1-4mm of blackborder and another 6-9mm - the alignment marks may be located in part of this 6-9mm distance, e.g. 7mm distance.) Thus, along the Y direction, the patterning device may have edge/TIS (6-9mm) - blackborder (1-4mm) - imaging area (132mm) - blackborder (1-4mm) - edge/TIS (6-9mm). Thus, a total of 152mm in the Y direction.

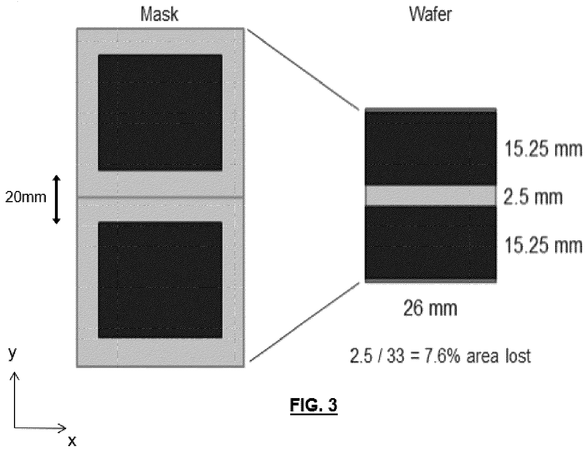

As shown in Figure 3, given the 10 mm borders in Y around the imaging area on both patterning devices, and magnification of 1/8x, this means that even with patterning devices (mask) touching there is a gap between these two fields of 2.5 mm (as opposed to -50 um normal scribe line) at substrate W level. The gap of 2.5mm is from 2x the distance from a second side of the imaging area to an adjacent edge of the patterning device (i.e. 2^{∗}10mm=20mm) multiplied by the magnification of 1/8x (20/8=2.5mm). This reduces the effective wafer (substrate) area by -8% (from 2.5mm/33mm=7.6%). This is undesired as it increases net costs of all the parallel processes in the wafer stack, like coat, develop, etch and depo.

The reason for this large border is that multi-layer and absorber coating processes in practice cannot be extended to the physical edge of the reticle with required sub-nm thickness accuracy, so the high-quality imaging area needs to maintain a sufficient margin to the physical edge of the reticle to ensure the tight specs on reflectivity uniformity.

Another issue is that even with these large margins, there will be variations over the reticle of both the multilayer as well as the absorber layers, leading to variations in local reflectivity and hence increased CD (critical dimension) variation (both local and global).

In embodiments, high-resolution reflectivity measurements of a patterning device blank prior to deposition of absorber are used to apply a correction to the local linewidth and/or optical proximity corrections features and/or sub-resolution assist features. These measurements may be similar to optical proximity corrections and in addition to nominal optical proximity corrections. This may improve the reflectivity and centre wavelength (13.5nm for EUV) related items.

Further, in embodiments, after absorber deposition on the patterning device, high-resolution reflectivity or ellipsometry measurements are used to determine local absorber thickness variations, and these measurements are used to apply a correction to the local linewidth and/or optical proximity corrections features and/or sub-resolution assist features. These measurements may be similar optical proximity corrections and in addition to nominal optical proximity corrections. This may improve the absorber and 3D related items.

These methods allow the imaging area to be shifted closer to the edge of the patterning device (where coating variations become larger and larger as one nears the physical edge of the reticle) than was previously possible whilst maintaining the required sub-nm thickness accuracy and thus keeping within the desired specifications for reflectivity uniformity.

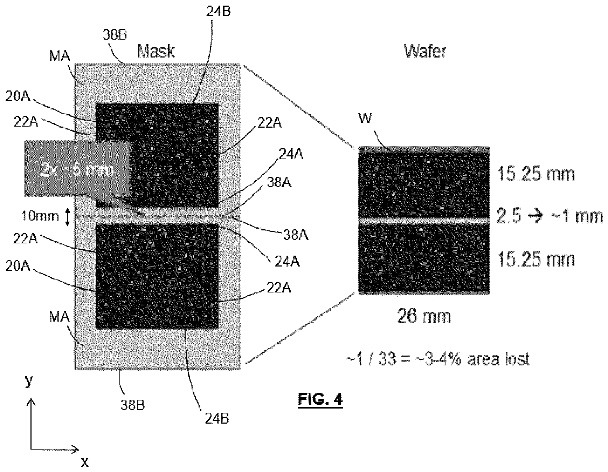

Figure 4 shows an embodiment of a patterning device MA adjacent to another patterning device MA in the scanning (Y) direction.

The patterning devices MA include an imaging area 20A having opposing first sides 22A extending parallel to a scanning (Y) direction of the lithographic apparatus LA and opposing second sides 24A, 24B extending perpendicularly to the scanning (X) direction. In embodiments, for both patterning devices MA, the imaging area 20A is shifted with respect to a patterning device centre in the scanning (Y) direction such that a first spacing between the second side 24A of the imaging area 20A to an adjacent edge 38A of the patterning device MA is less than a second spacing between the other of the second sides 24B of the imaging area 20A to an opposing adjacent edge 38B of the patterning device MA. In this embodiment, the first spacings are both ∼5mm.

As may be seen, adjacent edges 38A of the patterning devices MA are in contact with each other such that the distance between the two respective imaging areas 20A equals the first spacings of the respective patterning devices MA added together. In this embodiment, the first spacings are both ∼5mm, and thus the distance between the two respective imaging areas 20A of the adjacent patterning devices MA is ∼10mm. It will be appreciated that, in other embodiments, the distance between the respective imaging areas 20A may be different than ∼10mm, e.g. it may be less than 10mm. Preferably, the first spacing should be as small as possible. Therefore, a first spacing of 0.4 mm may be a target. In practice, the first spacing may be between 5-10 mm to allow for spacering, reticle bevels and edge effects in resist-coating; but all these might be improved on in future.

The two patterning devices MA (on an extended reticle stage) in Figure 4 have a gap between the two fields (imaging areas 20A) which is smaller than the gap the two fields for the two patterning devices in Figure 3. For example, two reticles with 12mm-3mm-132mm-3mm-2mm (edge/TIS - blackborder - imaging - blackborder - edge/TIS) would have a gap between the images on the substrate W of only 1.25 mm or <4% area lost. The gap of 1.25mm is from 2^{∗}5mm=10mm multiplied by the magnification of 1/8x (10/8=1.25mm). This reduces the effective wafer (substrate) area by -3-4% (from 1.25mm/33mm=3.8%).

It should be noted that 2 mm is ample room for the transmission image sensor (TIS) (which is also not sensitive to variations in reflectivity or absorber), and that TIS does not suffer from any overlap considerations (as it measures one reticle at a time and is bladed by a reticle masking module). Also, as long as the 3mm blackborder is maintained, there is no change for the reticle masking blading functionality.

The two patterning devices MA of Figure 4 also enable the emulation of a classical full-field on the NA=0.55 lithographic apparatus LA (33x26 mm), which would create full-throughput compatibility with other lithographic apparatus LA, which will reduce overall costs of the full wafer stack. This would go at the expense of -0.5x26 mm² on both half-fields on the substrate W to make room for the ∼1 mm in the middle.

An advantage may be enabling a full field to be imaged onto a substrate W for a lithographic apparatus LA having a numerical aperture (NA)=0.55 whilst reducing the % loss of the imaging area 20A imaged on the substrate W when compared to patterning devices with the imaging area centred in the patterning device.

There may be local and global critical dimension uniformity improvement and also edge placement error improvements. There may be a substrate area coverage improvement of -4% and/or higher throughput for the lithographic apparatus LA.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Clauses

1. A patterning device for a lithographic apparatus arranged to project a pattern from the patterning device onto a substrate, the patterning device comprising:
   an imaging area having opposing first sides extending parallel to a scanning direction of the lithographic apparatus and opposing second sides extending perpendicularly to the scanning direction, and
   at least one sensing mark located adjacent to at least one second side of the imaging area;
   wherein the at least one sensing mark is located a predetermined distance in the scanning direction away from the at least one second side of the imaging area and extends a width in the scanning direction such that the at least one sensing mark, when projected onto the substrate, fits within a scribe line on the substrate.
2. The patterning device according to clause 1, wherein the predetermined distance in the scanning direction is at least one of the width in the scanning direction of a blackborder adjacent to the imaging area, and substantially 3mm
3. The patterning device according to either of clauses 1 or 2, wherein the width in the scanning direction of the sensing mark is at least one of less than 200 micron and less than 400 micron.
4. The patterning device according to any preceding clause, wherein the sensing mark comprises an alignment mark.
5. The patterning device according to clause 4, wherein the alignment mark comprises a transmission image sensor, TIS, alignment mark.
6. The patterning device according to either of clauses 4 or 5, wherein the alignment mark comprises y and x fine-alignment marks.
7. The patterning device according to any of clauses 4-6, wherein the alignment mark comprises at least one coarse alignment mark, wherein the at least one coarse alignment mark is located in an area coverable with a reticle masking X-blade.
8. The patterning device according to any of clauses 4-7, further comprising at least one reference alignment mark, wherein the at least one reference alignment mark is located in an area coverable with a reticle masking X-blade.
9. A lithographic apparatus arranged to project a pattern from a patterning device onto a substrate, wherein the lithographic apparatus comprises an illumination system configured to condition a radiation beam, wherein the illumination system is configured to project the radiation beam onto the patterning device, and wherein the lithographic apparatus comprises the patterning device of any preceding clause.
10. A method of projecting onto a substrate at least one sensing mark on a patterning device according to any of clauses 1-8 such that the at least one sensing mark fits within a scribe line on the substrate.
11. The method of clause 10, wherein the sensing mark comprises an alignment mark, the method further comprising aligning the patterning device with the substrate using the alignment mark.
12. The method according to clause 11, further comprising measuring the XY-aligned position with a plurality of offsets in Y with the most accurate value being the one furthest from the patterning device.
13. The method according to either of clauses 11 or 12, further comprising using correction feedback or other overlay process control schemes to remove any residual patterning device alignment offsets.
14. A patterning device for a lithographic apparatus arranged to project a pattern from the patterning device onto a substrate, the patterning device comprising:
   an imaging area having opposing first sides extending parallel to a scanning direction of the lithographic apparatus and opposing second sides extending perpendicularly to the scanning direction;
   wherein the imaging area is shifted with respect to a patterning device centre in the scanning direction such that a first spacing between one of the second sides of the imaging area to an adjacent edge of the patterning device is less than a second spacing between the other of the second sides of the imaging area to an opposing adjacent edge of the patterning device.
15. The patterning device according to clause 14, wherein the first spacing is at least one of in a range of 0.4mm to 10mm, and in a range of 5 to 10mm.
16. The patterning device according to clause 15, wherein the first spacing is approximately 5mm.
17. The patterning device according to any of clauses 14-16, wherein the patterning device is positioned adjacent to another patterning device in the scanning direction, the adjacent edges of the patterning devices being in contact with each other such that the distance between the two respective imaging areas equals the first spacings of the respective patterning devices added together.
18. A method of using high-resolution reflectivity measurements of a patterning device blank prior to deposition of absorber to apply a correction to the local linewidth and/or optical proximity corrections features and/or sub-resolution assist features.
19. The method of clause 18, further comprising, after absorber deposition on the patterning device, using high-resolution reflectivity or ellipsometry measurements to determine local absorber thickness variations, and using these measurements to apply a correction to the local linewidth and/or optical proximity corrections features and/or sub-resolution assist features.
20. The method of either of clauses 18 or 19, wherein the patterning device comprises an imaging area having opposing first sides extending parallel to a scanning direction of a lithographic apparatus and opposing second sides extending perpendicularly to the scanning direction, the method further comprising shifting the imaging area with respect to a patterning device centre in the scanning direction such that a first spacing between one of the second sides of the imaging area to an adjacent edge of the patterning device is less than a second spacing between the other of the second sides.

## Claims

1. A patterning device for a lithographic apparatus arranged to project a pattern from the patterning device onto a substrate, the patterning device comprising:
an imaging area having opposing first sides extending parallel to a scanning direction of the lithographic apparatus and opposing second sides extending perpendicularly to the scanning direction, and
at least one sensing mark located adjacent to at least one second side of the imaging area;
wherein the at least one sensing mark is located a predetermined distance in the scanning direction away from the at least one second side of the imaging area and extends a width in the scanning direction such that the at least one sensing mark, when projected onto the substrate, fits within a scribe line on the substrate.

2. The patterning device according to claim 1, wherein the predetermined distance in the scanning direction is at least one of the width in the scanning direction of a blackborder adjacent to the imaging area, and substantially 3mm

3. The patterning device according to either of claims 1 or 2, wherein the width in the scanning direction of the sensing mark is at least one of less than 200 micron and less than 400 micron.

4. The patterning device according to any preceding claim, wherein the sensing mark comprises an alignment mark.

5. The patterning device according to claim 4, wherein the alignment mark comprises a transmission image sensor, TIS, alignment mark.

6. The patterning device according to either of claims 4 or 5, wherein the alignment mark comprises y and x fine-alignment marks.

7. The patterning device according to any of claims 4-6, wherein the alignment mark comprises at least one coarse alignment mark, wherein the at least one coarse alignment mark is located in an area coverable with a reticle masking X-blade.

8. The patterning device according to any of claims 4-7, further comprising at least one reference alignment mark, wherein the at least one reference alignment mark is located in an area coverable with a reticle masking X-blade.

9. A lithographic apparatus arranged to project a pattern from a patterning device onto a substrate, wherein the lithographic apparatus comprises an illumination system configured to condition a radiation beam, wherein the illumination system is configured to project the radiation beam onto the patterning device, and wherein the lithographic apparatus comprises the patterning device of any preceding claim.

10. A method of projecting onto a substrate at least one sensing mark on a patterning device according to any of claims 1-8 such that the at least one sensing mark fits within a scribe line on the substrate.

11. A patterning device for a lithographic apparatus arranged to project a pattern from the patterning device onto a substrate, the patterning device comprising:
an imaging area having opposing first sides extending parallel to a scanning direction of the lithographic apparatus and opposing second sides extending perpendicularly to the scanning direction;
wherein the imaging area is shifted with respect to a patterning device centre in the scanning direction such that a first spacing between one of the second sides of the imaging area to an adjacent edge of the patterning device is less than a second spacing between the other of the second sides of the imaging area to an opposing adjacent edge of the patterning device.

12. The patterning device according to claim 11, wherein the first spacing is at least one of in a range of 0.4mm to 10mm, and in a range of 5 to 10mm.

13. The patterning device according to claim 12, wherein the first spacing is approximately 5mm.

14. The patterning device according to any of claims 11-13, wherein the patterning device is positioned adjacent to another patterning device in the scanning direction, the adjacent edges of the patterning devices being in contact with each other such that the distance between the two respective imaging areas equals the first spacings of the respective patterning devices added together.

15. A method of using high-resolution reflectivity measurements of a patterning device blank prior to deposition of absorber to apply a correction to the local linewidth and/or optical proximity corrections features and/or sub-resolution assist features.
